**Europäisches Patentamt**

**European Patent Office**

**Office européen des brevets**

(19)

(11) Numéro de publication: **0 086 120**
**B1**

# (12) FASCICULE DE BREVET EUROPÉEN

(45) Date de publication du fascicule du brevet:
**13.08.86**

(21) Numéro de dépôt: **83400062.2**

(22) Date de dépôt: **11.01.83**

(51) Int. Cl.⁴: **H 01 J 37/02,** H 01 J 37/09, H 01 J 37/26

(54) **Appareil d'optique électronique comportant des éléments en graphite pyrolytique.**

(30) Priorité: **22.01.82 FR 8201010**

(43) Date de publication de la demande:
**17.08.83 Bulletin 83/33**

(45) Mention de la délivrance du brevet:
**13.08.86 Bulletin 86/33**

(84) Etats contractants désignés:
**DE GB**

(56) Documents cité:
**DE-A-3 010 376**
**FR-A-776 056**
**GB-A-1 066 583**
**US-A-3 634 684**

**THE REVIEW OF SCIENTIFIC INSTRUMENTS, vol. 42, no. 1, Janvier 1971, pages 14-15, New York (US); D.B. BALLARD et al.: "Spectrometer shield for stray iron X-Ray radiation in the scanning electron microscope"**

(73) Titulaire: **CAMECA, 103, Boulevard Saint- Denis, F-92400 Courbevoie (FR)**

(72) Inventeur: **Boissel, Pierre, THOMSON- CSF SCPI 173, bld Haussmann, F-75379 Paris Cedex 08 (FR)**
Inventeur: **Tong, Mathias, THOMSON- CSF SCPI 173, bld Haussmann, F-75379 Paris Cedex 08 (FR)**

(74) Mandataire: **Turlèque, Clotilde, THOMSON- CSF SCPI 19, avenue de Messine, F-75008 Paris (FR)**

## Description

L'invention se rapporte aux appareils d'optique électronique et plus particulièrement à un perfectionnement à ce type d'appareils.

Dans un microscope électronique à balayage, ou un microanalyseur par rayons X à sonde électronique, l'échantillon à observer ou à analyser est soumis à un bombardement par les électrons d'un faisceau électronique, généré dans un canon à électrons, puis défléchi et focalisé pour balayer l'échantillon.

Tout au long du trajet du faisceau electronique, les pièces situées à proximité immédiate de celui-ci sont frappées par des électrons primaires, et des électrons parasites rétrodiffusés viennent perturber le faisceau utile, entrainant une limitation de la résolution spatiale de l'appareil aussi bien en observation qu'en analyse X. Cette rétrodiffusion se produit notamment au niveau de l'anode du canon à electrons.

Pour résoudre, partiellement, ce problème, il est prévu dans certains appareils de ce type de disposer, à des endroits choisis, des écrans pour éliminer ces électrons parasites afin de limiter la perturbation du faisceau utile.

L'invention a pour objet un appareil d'optique électronique perfectionné en ce que le nombre d'électrons parasites venant perturber le faisceau est considérablement diminué par rapport à celui existant dans les appareils de ce type où habituellement les écrans de protection sont réalisés en métal, par exemple acier inoxydable ou alliages cuivreux.

Suivant l'invention, un appareil d'optique électronique comportant un canon à électrons, un bloc condenseur du faisceau électronique issu du canon, un bloc de déflexion et de focalisation du faisceau issu du bloc condenseur et un dispositif de détection de signal utile, et dans lequel les ecrans tubulaires entourant le faisceau à l'interieur du bloc condenseur et du bloc de déflexion sont formés d'une partie extérieure étanche au vide et d'une partie intérieure constituée de graphite pyrolytique; est caractérisé en ce que la face interne de la paroi latérale du canon à électrons est recouverte, au moins partiellement, d'une couche de graphite pyrolytique.

Il est à noter qu'il est connu par la demande de brevet allemand DE-A-3 010 376 de revêtir d'une couche de graphite la surface intérieure d'un tube qui forme un écran tubulaire entourant un faisceau de particules à l'intérieur du bloc de déflexion d'un appareil. Mais cette couche de graphite a pour objet d'empêcher l'accumulation d'électrons dispersés sur le support des enroulements de déflexion, en l'occurence sur le tube. Un tel propos n'est pas celui de la présente invention, ou c'est la limitationde la rétrodiffusion des électrons frappant des éléments de paroi qui est recherchée, et plus particulièrement au niveau du canon à électrons.

L'invention sera mieux comprise et d'autres caractéristiques apparaîtront à l'aide de la description qui suit en référence aux figures annexées.

- La figure 1 est une courbe donnant, en première approximation, les valeurs des coefficients de rétrodiffusion électronique d'un certain nombre de matériaux en fonction de leur numéro atomique moyen.

- La figure 2 est un schéma général d'un exemple d'appareil électronique suivant l'invention.

- Les figures 3, 4 et 5 sont des schémas de détails de l'appareil représenté sur la figure 2.

Suivant l'invention, l'appareil d'optique électronique est tel que, tout au long du trajet du faisceau électronique, les écrans et tubes situés à proximité immédiate du faisceau sont réalisés, au moins partiellement, en graphite pyrolytique pour réduire la génération des électrons parasites.

Ce matériau a en effet des propriétés particulières qui, conjuguées, en font un matériau particulièrement adapté à cette application.

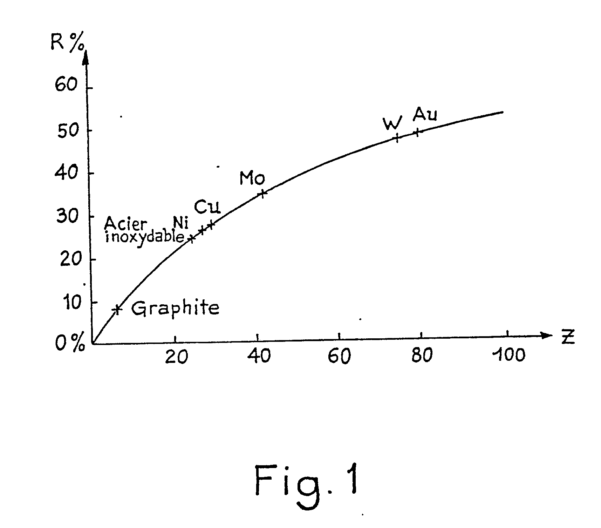

La première de ces propriétés est que le graphite a un coefficient de rétrodiffusion électronique notablement plus faible que les matériaux habituellement utilisés pour réaliser les écrans et les tubes situés au voisinage du faisceau, acier inoxydable ou alliages cuivreux par exemple. Le coefficient de rétrodiffusion électronique, R (en pourcentage), diminue en effet avec le numéro atomique des matériaux. La figure 1 représente cette variation de R en fonction de Z, les points relatifs à l'acier inoxydable (matériau généralement utilisé pour constituer l'anode du canon à électrons, les tubes et les écrans), a l'or (Au), au tungstène (W), au molybdene (Mo) au cuivre (Cu) et au nickel (Ni) ayant été repérés sur cette courbe.

Cependant, pour réaliser ces pièces dans un appareil d'optique électronique, il est également indispensable que les propriétés thermiques et mécaniques du matériau choisi soient convenables. En effet, dans ce type d'appareils les contraintes thermiques peuvent être importantes et un simple dépôt de graphite industriel ne présenterait pas les qualités suffisantes de stabilité thermique et mécanique.

Le graphite pyrolytique présente des avantages déterminants. Ce graphite, aussi appelé graphite "orienté", est essentiellement un graphite cristalisé obtenu par décomposition thermique d'un hydrocarbure gazeux sur la surface d'un matériau porté à une très haute température sous atmosphère controlée. L'épaisseur de la couche obtenue dépend de la durée du procédé de décomposition. Les conditions dans lesquelles s'effectue le dépôt influent sur la structure et les propriétés mécaniques de la couche obtenue.

Du point de vue thermique, ce matériau presente une grande résistance aux chocs thermiques et une grande stabilité. De plus le graphite pyrolytique a une grande capacité de rayonnement thermique.

Par ailleurs, sa résistance mécanique est très grande et contrairement à ce qui se produit pour d'autres matériaux, elle augmente avec la température.

L'introduction de pièces constituées ou recouvertes de ce matériau dans un appareil d'optique électronique du type microscope électronique à balayage ou microsonde, tout au long du trajet du faisceau électronique, permet d'améliorer le pouvoir de résolution de ces appareils.

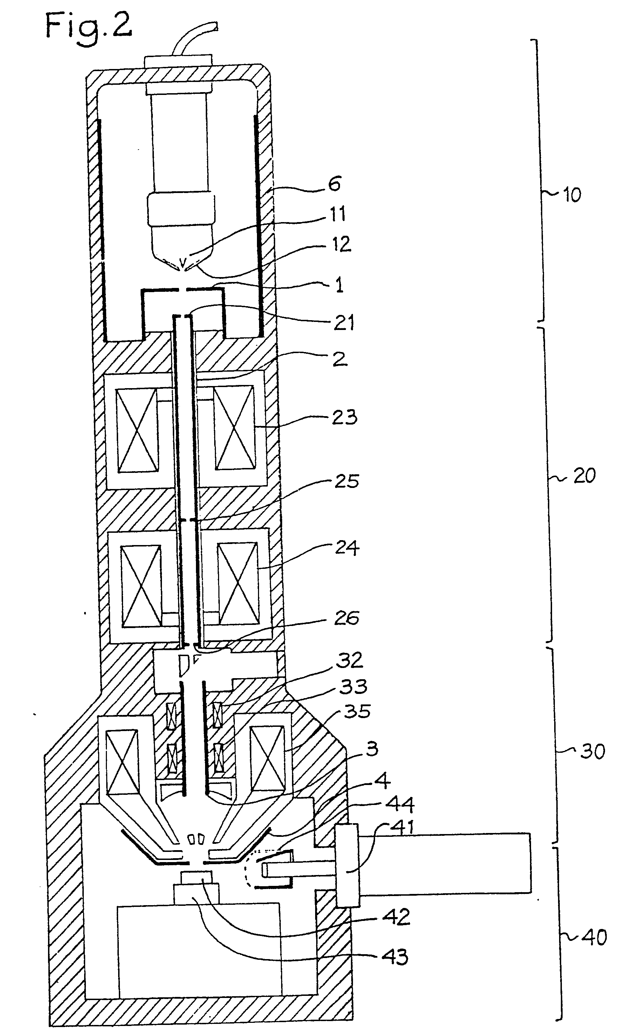

La figure 2 représente schématiquement un microscope électronique dans lequel ce perfectionnement est mis en oeuvre.

Ce type d'appareil comporte principalement quatre zones: le canon électronique 10 dans lequel est généré un faisceau d'électrons, un bloc condenseur 20, dans lequel le faisceau initial subit normalement une réduction importante d'intensité pour fournir à sa sortie le faisceau utile, un bloc de déflexion et de focalisation 30, dans lequel ce faisceau est dévié pour le balayage de l'échantillon à analyser puis focalisé sur cet échantillon, et enfin la chambre 40 dans laquelle est placé l'échantillon à analyser ainsi que le dispositif de détection des électrons secondaires.

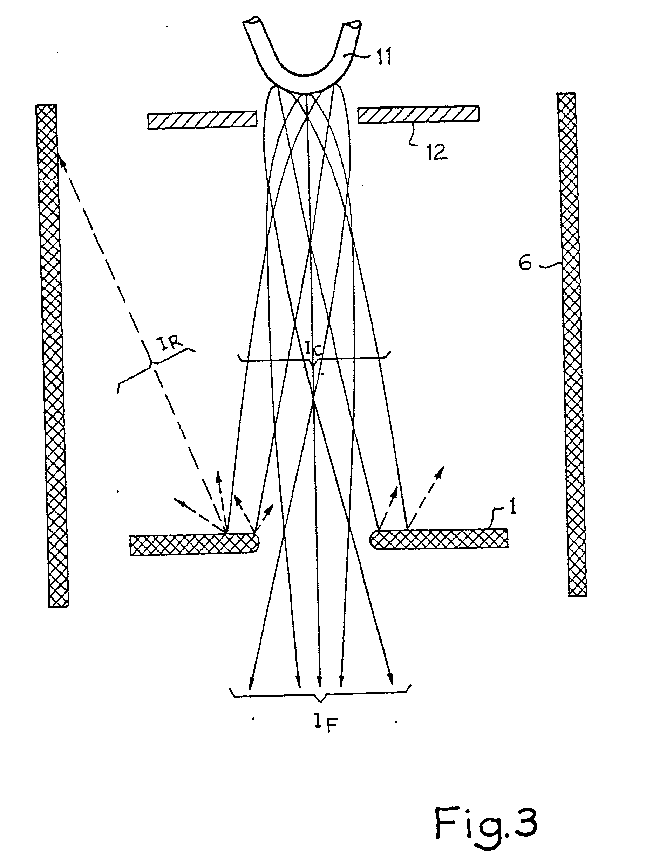

Le canon à électrons comporte principalement le filament 11, le Wehnelt 12 et l'anode 1 dans une enceinte à vide et leurs moyens d'alimentation, non décrits en détail ici. La figure 3 représente les éléments essentiels 11, 12, 1 de ce canon. L'anode est un disque percé en son centre pour le passage du faisceau. Une partie du faisceau d'électrons d'intensité $I_c$ émis par le filament est transmise au bloc condenseur (soit $I_F$ l'intensité électronique du faisceau à l'entrée de ce bloc). Une autre partie frappe l'anode 1 et est elle-même en partie rétrodiffusée. Dans la version la plus perfectionnée de l'appareil suivant l'invention, cette anode 1 est réalisée en graphite pyrolytique, ce qui permet de réduire considérablement l'intensité du faisceau d'électrons réémis, $I_R$, typiquement d'un facteur 5 par rapport à l'intensité rétrodiffusé par une anode en acier inoxydable par exemple. Comme le courant électronique reçu par l'anode est élevé, une ou plusieurs centaines de micro-ampères pour un courant d'émission électronique secondaire détecté, après analyse de l'échantillon, de l'ordre du pico-ampère, l'anode produit habituellement jusqu'à quelques dizaines de micro-ampères d'électrons parasites difficiles à éliminer par des pièges. Une anode constituée de graphite pyrolytique conduit à un faisceau initial plus "propre" et à une charge d'espace plus faible, ce qui améliore les qualités du canon.

Un perfectionnement, réprésenté sur les figures 2 et 3, consiste à réaliser un blindage, 6, également constitué d'une couche de graphite pyrolytique sur la face latérale interne du canon électronique.

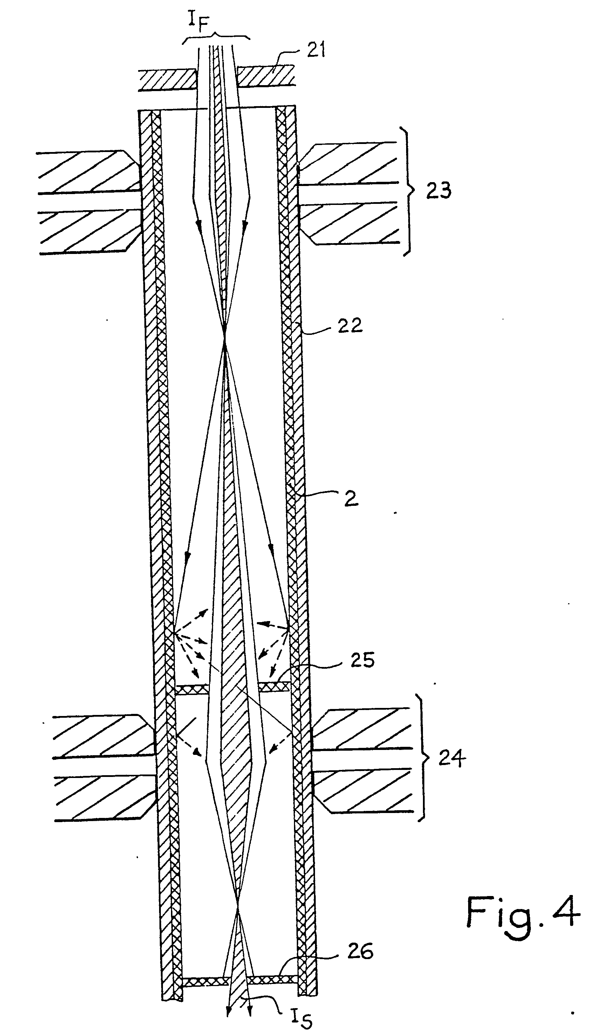

Dans le bloc condenseur 20, représenté plus en détails sur la figure 4, le faisceau initial issu du canon, d'intensité $I_F$, est concentré par des lentilles électro-magnétiques 23, 24 et traverse un ou plusieurs diaphragmes limiteurs 21, 25, 26 pour fournir un faisceau utile d'intensité $I_S$ comprise entre le pico-ampère et quelques centaines de nano-ampères et des électrons parasites provenant des rétrodiffusions d'électrons sur les diaphragmes sur les tubes de protection. Selon une caractéristique essentielle de l'invention, le tube de protection 2 est constitué de graphite pyrolytique ce qui diminue notablement, à ce niveau de l'appareil, le taux d'électrons parasites. En pratique, compte-tenu du fait que le tube doit également assurer l'étanchéité au vide, celui-ci comporte une partie extérieure en métal 22 et une partie intérieure, 2, en graphite pyrolytique. Les diaphragmes limiteurs peuvent également être avantageusement constitués de graphite pyrolytique. Sur la figure 4, les diaphragmes 25 et 26 ont été représentés comme constitués de ce matériau.

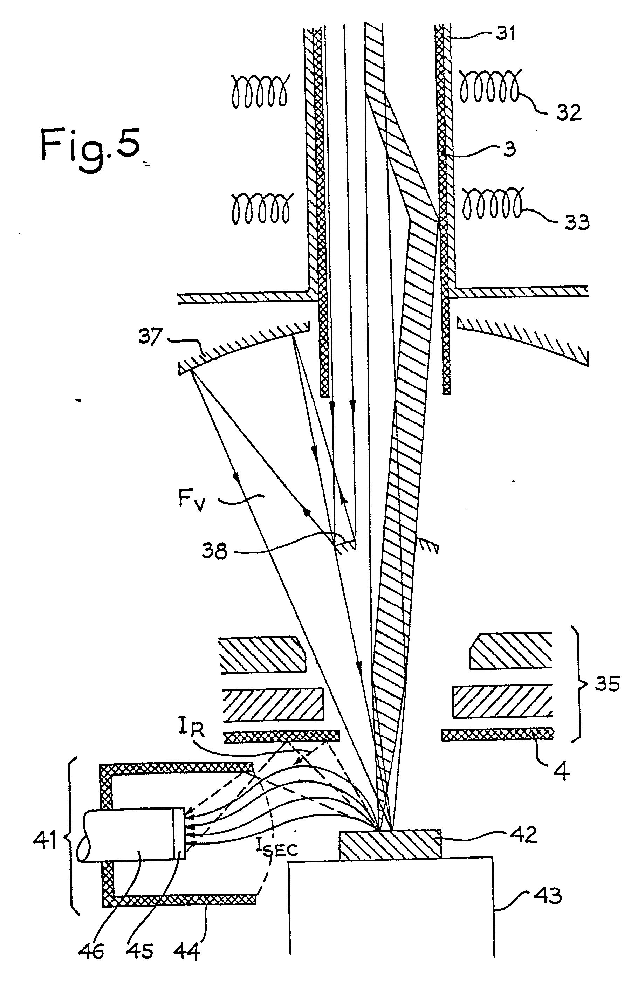

Dans le bloc de déflexion 5, représenté plus en détails sur la figure 5, le faisceau ne subit plus d'atténuation, mais seulement une succession de déflexions par des bobines de déplacement 32 et 33. Le faisceau a été représenté sans déflexion et avec déflexion (faisceau hachuré). L'appareil comporte à ce niveau un écran tubulaire qui piège les électrons parasites résiduels sortant du bloc condenseur. Selon une seconde caractéristique essentielle de l'invention, cet écran tubulaire est formé, comme le tube de protection du bloc condenseur, d'une partie extérieure en métal 31 et d'une partie intérieure, 3, en graphite pyrolytique.

Dans un mode de réalisation, ce type d'instrument comporte également des moyens d'observation en lumière visible représentés (partiellement) sur la figure 5. Pour que l'observation soit faite dans de bonnes conditions, il est souhaitable que l'écran tubulaire du bloc de déflexion à l'intérieur duquel passe le faisceau de lumière visible, $F_V$, focalisé par l'objectif photonique 37, 38, ait un faible pouvoir réflecteur. Le graphite pyrolytique, se rapprochant d'un corps noir, remplace avantageusement un quelconque revêtement anti-reflet qui pourrait dégazer et détériorer les conditions de vide dans l'appareil.

Le faisceau électronique défléchi est ensuite focalisé par une lentille de focalisation 35 sur l'échantillon 42 porté par un porte objet 43.

Dans la dernière zone de l'appareil, le faisceau électronique frappant l'échantillon, d'intensité utile $I_u$, donne lieu à l'émission d'électrons secondaires d'intensité $I_{sec}$ caractéristique de l'échantillon et signal utile à détecter par le dispositif de détection 41. Mais du fait de la rétrodiffusion d'électrons primaires par l'échantillon 42 puis par la surface de la dernière pièce sur l'axe du faisceau, des électrons parasites d'intensité $I'_R$ sont également reçus par le détecteur et viennent perturber le signal utile. En outre dans certains modes de réalisation un écran 4 refroidi à la température de l'azote liquide est placé entre la lentille de focalisation 35, et l'objet de façon à améliorer les conditions de vide dans l'appareil et ainsi à diminuer la contamination de l'objet par les dépôts d'hydrocarbure qui se produisent sous l'effet de l'impact du faisceau. Les réémissions électroniques multiples entre l'échantillon et cet écran donnent lieu sur le détecteur à un signal parasite.

Selon une caractéristique complémentaire de l'appareil suivant l'invention, l'écran 4 dit écran "anticontamination" est également constitué de graphite pyrolytique, ce qui réduit considérablement le signal parasite. Cet écran peut être un disque, percé en son centre ou une calotte de révolution autour de l'axe du faisceau, épousant la forme de la dernière pièce de l'appareil à proximité du faisceau.

Le dispositif de détection 41 est constitué dans le mode de réalisation représenté d'une électrode collectrice 44, d'un scintillateur 45 et d'un guide de lumière 46 couplé à un photomultiplicateur non représenté. L'électrode collectrice 44 a pour rôle de créer un champ électrique permettant de capter les électrons secondaires constituant le signal utile; ceux-ci sont ensuite attirés par le scintillateur, lui-même polarisé très positivement. Cependant les électrons rétrodiffusés par l'objet et son environnement atteignent cette électrode, qui les rétrodiffuse en partie de telle sorte que certains atteignent le scintillateur et constituent un signal parasite.

Pour réduire l'intensité de ce signal, cette électrode collectrice 44 est également réalisée en graphite pyrolytique.

L'invention n'est pas limitée à l'appareil décrit en référence aux figures et il est du domaine de l'invention d'ajouter aux éléments précisément décrits ci-dessus d'autres écrans ou diaphragmes limiteurs constitués de graphite pyrolytique le long du trajet du faisceau électronique là où des phénomènes de rétrodiffusion notables interviendraient et perturberaient le bon fonctionnement de l'appareil.


## Revendications

1. Appareil d'optique électronique comportant un canon à électrons (10), un bloc condenseur (20) du faisceau électronique issu du canon, un bloc de déflexion et de focalisation du faisceau issu du bloc condenseur et un dispositif de détection de signal utile, et dans lequel les écrans tubulaires entourant le faisceau à l'intérieur du bloc condenseur et du bloc de déflexion sont formés d'une partie extérieure étanche au vide (22, 31) et d'une partie intérieure constituée de graphite pyrolytique (2, 3), caractérisé en ce que la face interne de la paroi latérale du canon à électrons (10) est recouverte, au moins partiellement, d'une couche (6) de graphite pyrolytique.

2. Appareil selon la revendication 1, caractérisé en ce que l'anode (1) du canon à électrons (10) est une pièce de révolution constituée de graphite pyrolytique percée d'un trou pour le passage du faisceau.

3. Appareil selon l'une des revendications précédentes, caractérisé en ce que la lentille de focalisation (35) du faisceau électronique est séparée du porte objet (43) par un écran anticontamination (4) constitué de graphite pyrolytique.

4. Appareil selon l'une quelconque des revendications précédentes, caractérisé en ce que le tube condenseur comporte au moins un diaphragme limiteur (25, 26), en forme de disque percé d'un trou, constitué de graphite pyrolytique.

5. Appareil selon l'une quelconque des revendications précédentes, caractérisé en ce que le dispositif de détection de signal utile comporte une électrode collectrice (44) constituée de graphite pyrolytique.


## Patentansprüche

1. Elektronenoptisches Gerät mit einer Elektronenkanone (10), einem Kondensatorblock (20) für das von der Kanone abgegebene Elektronenbündel, einem Ablenk- und Fokussierblock für das von dem Kondensatorblock abgegebene Bündel und einer Detektionsvorrichtung für das Nutzsignal, worin ferner die rohrförmigen, das Bündel innerhalb des Kondensatorsblocks und des Ablenkblocks umgebenden Schirme aus einem vakuumdichten äußeren Teil (22, 31) und einem inneren, aus pyrolytischem Graphit bestehenden Teil (2, 3) gebildet sind, dadurch gekennzeichnet, daß die Innenfläche der Seitenwand der Elektronenkanone (10) wenigstens teilweise mit einer Schicht (6) aus pyrolytischem Graphit bedeckt ist.

2. Gerät nach Anspruch 1, dadurch gekennzeichnet, daß die Anode (1) der Elektronenkanone (10) ein rotationssymmetrisches Teil ist, welches aus pyrolytischem Graphit mit einem Durchgangsloch für das Bundel besteht.

3. Gerät nach einem der vorstehenden Ansprüche, dadurch gekennzeichnet, daß die Fokussierlinse (35) für das Elektronenbündel von dem Objektträger (43) durch einen Verunreinigungsschutzschirm (24) getrennt ist, welcher aus pyrolytischem Graphit gebildet ist.

4. Gerät nach einem der vorstehenden Ansprüche, dadurch gekennzeichnet, daß das Kondensatorrohr wenigstens eine Begrenzungsblende (25, 26) in Form einer mit einem Loch versehenen und aus pyrolytischem Graphit gebildeten Scheibe entnält.

5. Gerät nach einem der vorstehenden Ansprüche, dadurch gekennzeichnet, daß die Detektionsvorrichtung für das Nutzsignal eine Sammelelektrode (44) umfaßt, die aus pyrolytischem Graphit besteht.


## Claims

1. Electron optics apparatus comprising an electron gun (10), a condenser block (20) for the electron beam originating from the gun, a deflection and focussing block for the beam received from the condenser block and a detection device for the useful signal, and wherein the tubular screens surrounding the beam inside of the condenser block and of the deflection block are formed of an external vacuum tight portion (22, 31) and of an internal portion formed of pyrolytic graphite (2, 3), characterized in that the internal face of the lateral wall of the electron gun (10) is at least partially covered with a layer (6) of pyrolytic graphite.

2. Apparatus according to claim 1, characterized in that the anode (1) of the electron gun (10) is a piece of revolution formed of pyrolytic graphite and pierced with a hole for the passage of the beam.

3. Apparatus according to any of the preceding claims, characterized in that the focussing lens (35) of the electron beam is separated from the object carrier (43) by a contamination protection screen (4) formed of pyrolytic graphite.

4. Apparatus according to any of the preceding claims, characterized in that the condenser tube comprises at least one limiting diaphragm (25, 26) formed as a disk pierced with a hole and formed of pyrolytic graphite.

5. Apparatus according to any of the preceding claims, characterized in that the detection device for the useful signal comprises a collector electrode (44) formed of pyrolytic graphite.

Fig. 1

Fig.2

Fig.3

Fig.4

Fig.5